# EUROPÄISCHE PATENTANMELDUNG

(11) **EP 0 862 207 A1**
(43) Veröffentlichungstag der Anmeldung: **02.09.1998**
(21) Anmeldenummer: 98101309.7
(22) Anmeldetag: 26.01.1998
(51) Int. Cl.: H01L 21/8242

(54) **Verfahren zur Herstellung eines DRAM-Grabenkondensators**

(30) Priorität: 27.02.1997 DE 19707978
(71) Anmelder: SIEMENS AKTIENGESELLSCHAFT, 80333 München (DE)
(72) Erfinder: Franosch, Martin, 81739 München (DE); Hönlein, Wolfgang, Dr., 82008 Unterhaching (DE); Lange, Gerrit, Dr., 81373 München (DE); Lehmann, Volker, Dr., 80689 München (DE); Reisinger, Hans, Dr., 82031 Grünwald (DE); Schäfer, Herbert, Dr., 85635 Höhenkirchen-Siegertsbrunn (DE); Stengl, Reinhard, Dr., 86391 Stadtbergen (DE); Wendt, Hermann, Dr., 85630 Grasbrunn (DE); Widmann, Dietrich, Dr., 82008 Unterhaching (DE); Klose, Helmut, Dr., New York 12603 (US)

(57) **Zusammenfassung**

Zur Herstellung eines Kondensators, insbesondere für eine dynamische Speicherzellenanordnung, wird in einem Substrat ein Graben geätzt. Im Graben wird eine Schichtenfolge (16,17,18) erzeugt, die alternierend Schichten aus dotiertem Silizium (17) und germaniumhaltige Schichten (16,18) enthält. Durch anisotropes Ätzen wird die Oberfläche des Halbleitersubstrats (12) im Bereich des Grabenbodens freigelegt. Die Gräben werden mit einer leitfähigen Stützstruktur (20) aufgefüllt. Die germaniumhaltigen Schichten werden selektiv zu den Schichten aus dotiertem Silizium entfernt. Die freiliegende Oberfläche der Schichten aus dotiertem Silizium (17) und der Stützstruktur (20) werden mit einem Kondensatordielektrikum (22) versehen, auf das eine Gegenelektrode (23) aufgebracht wird.

## Beschreibung

Für verschiedene integrierte Schaltungstypen, wie zum Beispiel dynamische Speicherzellenanordnungen, Analog Digital-und Digital Analog-Wandler sowie Filterschaltungen, werden Kondensatoren auf Halbleiterbasis benötigt. Bei der Herstellung von Kondensatoren auf Halbleiterbasis ist im Hinblick auf eine erhöhte Integrationsdichte oder reduzierte Chipflache das Problem zu lösen, den Platzbedarf des Kondensators bei gleichbleibender Kapazität zu reduzieren.

Dieses Problem ist besonders gravierend bei dynamischen Halbleiterspeichern, bei denen die benötigte Fläche der im allgemeinen verwendeten Eintransistorspeicherzelle von Speichergeneration zu Speichergeneration mit zunehmender Speicherdichte reduziert wird. Gleichzeitig muß eine gewisse Mindestkapazität des Speicherkondensators erhalten bleiben.

Eine Eintransistorspeicherzelle einer dynamischen Halbleiterspeicheranordnung (DRAM-Speicheranordnung) umfaßt einen Auslesetransistor und einen Kondensator. In dem Kondensator ist die Information in Form einer elektrischen Ladung gespeichert, die eine logische Größe, Null oder Eins, darstellt. Durch Ansteuerung des Auslesetransistors über eine Wortleitung kann diese Information über eine Bitleitung ausgelesen werden. Zur sicheren Speicherung der Ladung und gleichzeitigen Unterscheidbarkeit der ausgelesenen Information muß der Kondensator eine Mindestkapazität aufweisen. Die untere Grenze für die Kapazität des Speicherkondensators wird derzeit bei 25 fF gesehen.

Bis zur 1MBit-Generation wurden sowohl der Auslesetransistor als auch der Kondensator als planare Bauelemente realisiert. Ab der 4MBit-Speichergeneration wurde eine weitere Flächenreduzierung der Speicherzelle durch eine dreidimensionale Anordnung von Auslesetransistor und Speicherkondensator erzielt. Eine Möglichkeit dafür besteht darin, den Speicherkondensator in einem Graben zu realisieren (siehe zum Beispiel K. Yamada et al, Proc. Intern. Electronic Devices and Materials IEDM 85, Seite 702 ff). Die Elektroden des Speicherkondensators sind in diesem Fall entlang der Oberfläche des Grabens angeordnet. Dadurch wird die effektive Fläche des Speicherkondensators, von der die Kapazität abhängt, gegenüber dem Platzbedarf an der Oberfläche des Substrats für den Speicherkondensator, der dem Querschnitt des Grabens entspricht, vergrößert.

Eine weitere Möglichkeit, zur Vergrößerung der Speicherkapazität bei gleichbleibendem oder verringertem Platzbedarf des Speicherkondensators besteht darin, den Speicherkondensator als Stapelkondensator, den sogenannten stacked capacitor, auszuführen. Dabei wird über den Wortleitungen eine Struktur aus Polysilizium, zum Beispiel eine Kronenstruktur oder ein Zylinder, gebildet, die mit dem Substrat kontaktiert wird. Diese Polysiliziumstruktur bildet den Speicherknoten. Er wird mit Kondensatordielektrikum und Kondensatorplatte versehen. Dieses Konzept hat den Vorzug, daß es weitgehend mit einem Logikprozeß kompatibel ist.

Für den Speicherkondensator wird der freie Raum oberhalb der Substratoberfläche genutzt. Dabei kann die gesamte Zellfläche von der Polysiliziumstruktur überdeckt sein, solange die Polysiliziumstrukturen zu benachbarten Speicherzellen gegeneinander isoliert sind.

Aus EP 0 415 530 B1 ist eine Speicherzellenanordnung mit einem Stapelkondensator als Speicherkondensator bekannt. Der Stapelkondensator umfaßt eine Polysiliziumstruktur mit mehreren, im wesentlichen parallel übereinander angeordneten Polysiliziumschichten, die über mindestens eine seitliche Stütze miteinander verbunden sind. Diese kühlrippenartig angeordneten Schichten führen zu einer deutlichen Vergrößerung der Oberfläche der Polysiliziumstruktur gegenüber der Projektion der Polysiliziumstruktur auf die Substratoberfläche. Die Polysiliziumstruktur wird durch alternierende Abscheidung von Polysiliziumschichten und selektiv dazu ätzbaren SiO₂-Schichten auf der Oberfläche des Substrats, Strukturierung dieser Schichten, Erzeugung von Flankenbedeckungen (spacer) aus Polysilizium an mindestens einer Flanke der Schichtstruktur und selektives Herausätzen der SiO₂-Schichten gebildet.

Die Fläche für eine Speicherzelle eines DRAM in der 1GBit-Generation soll nur etwa 0,2 µm² betragen. Um auf einer derartigen Fläche die Mindestkapazität für den Speicherkondensator von 25 fF zu realisieren, muß, bei einem Grabenkondensatorkonzept, die aktive Grabentiefe mindestens 4 µm bei einer Grabenweite von 0,2 x 0,25 µm² und einem Dielektrikum mit einer oxidäquivalenten Dicke von 5 nm, betragen. Gräben mit derartigen Abmessungen sind nur in aufwendigen Ätzprozessen mit hohen Ätzzeiten realisierbar. In einem Stapelkondensatorkonzept sind diese Anforderungen an den Flächenbedarf einer Speicherzelle nur mit einer relativ komplizierten Struktur der Polysiliziumstruktur machbar. Diese komplizierten Strukturen sind zusätzlich durch ihre Topologie immer schwieriger herstellbar.

In DE 195 26 952 A1 ist ein Verfahren zur Herstellung einer DRAM- Speicherzellenanordnung vorgeschlagen worden, bei dem der Kondensator als Grabenkondensator mit vergrößerter Oberfläche ausgebildet wird. Dazu wird in einem Graben eine Folge alternierender Schichten gebildet, die aus p⁺-dotiertem bzw. p⁻-dotiertem Polysilizium bestehen. In der Mitte des Grabens wird eine Stützstruktur gebildet, die die Schichten aus p⁺-dotiertem Polysilizium mechanisch und elektrisch miteinander verbindet. Anschließend werden die Schichten aus p⁻-dotiertem Polysilizium selektiv entfernt. Da die Selektivität des dabei verwendeten Ätzverfahrens stark von der Dotierstoffkonzentration abhängig ist, ist das Verfahren auf geringe Prozeßtemperaturen beschränkt, bei denen ein Auseinanderdiffundieren der Dotierstoffprofile in der Schichtenfolge vermieden wird.

Der Erfindung liegt das Problem zugrunde, ein Verfahren zur Herstellung eines Kondensators für eine Halbleiteranordnung, insbesondere für eine DRAM-Anordnung anzugeben, bei dem gegenüber den bekannten Lösungen der Prozeßaufwand reduziert wird. Insbesondere sollen die Kondensatoren mindestens in der für die 1 GBit-Generation erforderlichen Packungsdichte herstellbar sein.

Dieses Problem wird erfindungsgemaß gelöst durch ein Verfahren gemäß Anspruch 1. Weitere Ausgestaltungen der Erfindung gehen aus den übrigen Ansprüchen hervor.

In dem Verfahren wird für den Kondensator in eine Hauptfläche des Halbleitersubstrats ein Graben geätzt. Als Halbleitersubstrat wird zum Beispiel eine monokristalline Siliziumscheibe oder die monokristalline Siliziumschicht eines SOI-Substrates verwendet. Mindestens in dem Graben wird eine Schichtenfolge abgeschieden, die jeweils alternierend eine Schicht aus dotiertem Silizium und eine germaniumhaltige Schicht aufweist. Die Schichten aus dotiertem Silizium können sowohl n- als auch p-dotiert sein. Die Schichten aus dotiertem Silizium und die germaniumhaltigen Schichten können sowohl polykristallin als auch epitaktisch abgeschieden werden. Die Schichtenfolge kann beliebig viele germaniumhaltige Schichten und Schichten aus dotiertem Silizium aufweisen. Sie muß mindestens eine germaniumhaltige Schicht aufweisen.

In der Mitte des Grabens werden durch anisotropes Rückätzen der Schichtenfolge am Grabenboden angeordnete Teile der Schichten entfernt. Dabei bleiben die entlang den Flanken des Grabens angeordneten Schichtteile ähnlich einem Spacer stehen. Durch anschließende Abscheidung einer elektrisch leitfähigen Schicht zum Beispiel aus dotiertem Silizium von demselben Leitfähigkeitstyp wie die Schichten aus dotiertem Silizium wird eine Stützstruktur gebildet. Die Stützstruktur reicht bis zum Grabenboden.

Die germaniumnaltigen Schichten werden durch selektives Ätzen entfernt. Die Ätzung ist selektiv zu den Schichten aus dotiertem Silizium und der Stützstruktur. Dadurch wird eine Elektrodenstruktur, die aus den Schichten aus dotiertem Silizium und der Stützstruktur zusammengesetzt ist, gebildet.

Die Stützstruktur steht mit allen Schichten aus dotiertem Silizium elektrisch und mechanisch in Verbindung, so daß sich nach Entfernen der germaniumhaltigen Schichten die zusammenhängende Elektrodenstruktur ergibt.

Die Oberfläche der Elektrodenstruktur, die herstellungsgemäß gegenüber dem Querschnitt des Grabens vergrößert ist, wird mit einem Kondensatordielektrikum versehen, an dessen Oberfläche eine Gegenelektrode gebildet wird.

Vorzugsweise werden die Schichten aus dotiertem Silizium in einem CVD-Prozeß unter Verwendung von Silan als Prozeßgas im Temperaturbereich zwischen 400 und 600°C bei einem Druck zwischen 10 und 400 Torr und einem Silanfluß von 30 bis 300 sccm mit Abscheideraten von 10 bis 100 nm pro Minute gebildet. Die germaniumnaltigen Schichten werden vorzugsweise durch CVD-Abscheidung unter Verwendung von German bzw. German und Disilan im Prozeßgas bei einer Temperatur zwischen 400 und 600°C und einem Druck zwischen 10 und 400 Torr gebildet, wobei der Germanfluß und gegebenenfalls der Disilanfluß zwischen 30 und 300 sccm eingestellt wird und die Abscheiderate zwischen 10 und 100 nm pro Minute liegt.

Die Schichten aus dotiertem Silizium werden vorzugsweise in situ dotiert abgeschieden. Dazu wird der Abscheidung ein Dotiergas, zum Beispiel Arsin, Phosphin oder Diboran. Die Schichten aus dotiertem Silizium und die Stützstruktur können sowohl aus n-dotiertem als auch aus p-dotiertem Silizium gebildet werden.

Dotiertes Silizium und Germanium können in demselben Reaktor abgeschieden werden. Dadurch kann die Schichtenfolge ohne Anlagenwechsel nur durch Umschalten der Prozeßparameter realisiert werden. Dieses bedeutet eine deutliche Prozeßvereinfachung.

Es liegt im Rahmen der Erfindung, die germaniumhaltigen Schichten aus reinem Germanium oder aus Silizium und Germanium zu bilden. Werden die Schichten aus Silizium und Germanium gebildet, so liegt der Germaniumanteil vorzugsweise zwischen 10 Prozent und 100 Prozent. Der Siliziumanteil liegt zwischen 0 Prozent und 90 Prozent. Die germaniumhaltigen Schichten können sowohl dotiert als auch undotiert abgeschieden werden.

Germaniumhaltige Schichten aus reinem Germanium oder aus Silizium und Germanium lassen sich naßchemisch mit guter Selektivität zu Silizium ätzen. Bei Verwendung einer Ätzmischung, die HF, H₂O₂ und CH₃COOH enthält, beträgt die Selektivität der Ätzung zu Silizium 1:30 bis 1:1000. Bei dieser Ätzung beträgt die Selektivität zu Siliziumoxid und Siliziumnitrid etwa 1:30 bis 1:1000. Mit Cholin lassen sich Siliziumschichten selektiv zu Germanium ätzen.

Da die Diffusionskoeffizienten von Germanium in Silizium und von Silizium in Germanium äußerst gering sind, bleibt die Schichtenfolge auch bei prozeßbedingten Temperaturbelastungen von zum Beispiel 800°C unverändert erhalten. Die Diffusionskoeffizienten liegen bei einer Prozeßtemperatur von 1000°C etwa bei 1,5 x 10⁻¹⁶ cm²/sec. Zum Vergleich: diese Diffusionskoeffizienten sind damit etwa um einen Faktor 10 geringer als der Diffusionskoeffizient von Bor in Silizium.

Eine weitere Vergrößerung der effektiven Oberfläche des Kondensators wird dadurch erzielt, daß an der Oberfläche des Graben ein dotiertes Gebiet gebildet wird, das elektrisch und mechanisch mit der Stützstruktur verbunden ist und das ebenfalls Bestandteil der Elektrodenstruktur ist.

Im folgenden wird die Erfindung anhand von Figuren und von Ausführungsbeispielen näher erläutert.
- Figur 1: zeigt ein Substrat, in das ein Graben geätzt ist und auf das eine Schichtenfolge abgeschieden ist.
- Figur 2: zeigt das Substrat nach anisotropem Rückätzen der Schichtenfolge, wobei der Grabenboden teilweise freigelegt ist.
- Figur 3: zeigt das Substrat nach ganzflächiger Abscheidung einer dotierten Polysiliziumschicht.
- Figur 4: zeigt das Substrat nach Rückätzen der dotierten Polysiliziumschicht und selektivem Ätzen von germaniumhaltigen Schichten des Schichtaufbaus.
- Figur 5: zeigt das Substrat nach Bildung eines Kondensatordielektrikums und einer Gegenelektrode.
- Figur 6: zeigt einen fertigen Speicherkondensator mit einem Auswahltransistor.

Die Darstellungen in den Figuren sind nicht maßstabsgetreu.

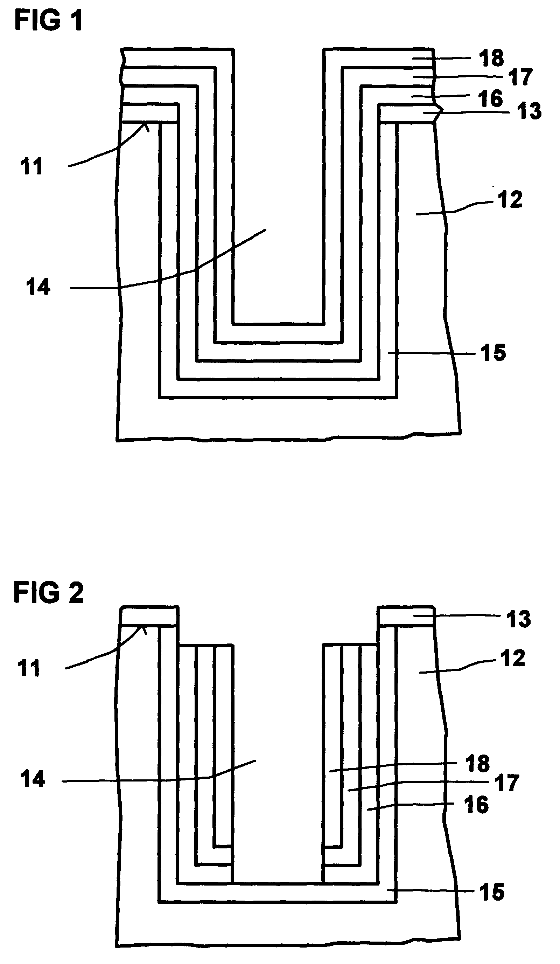

Auf einer Hauptfläche 11 eines Substrats 12 aus zum Beispiel n-dotiertem, monokristallinem Silizium mit einer Dotierstoffkonzentration von 5 x 10¹⁵ cm⁻³ wird eine Grabenmaske 13 gebildet (siehe Figur 1). Die Grabenmaske 13 wird zum Beispiel durch Abscheidung einer SiO₂-Schicht in einem TEOS-Verfahren in einer Schichtdicke von 500 nm und anschließende Strukturierung der SiO₂-Schicht gebildet.

Unter Verwendung der Grabenmaske 13 als Ätzmaske wird in einem anisotropen Ätzprozeß, zum Beispiel mit Cl₂/O₂ ein Graben 14 geätzt. Der Graben 14 weist einen Durchmesser von zum Beispiel 0,2 µm und eine Tiefe von zum Beispiel 2,5 µm auf.

Durch Diffusion wird im Substrat 12 ein dotiertes Gebiet 15 gebildet, das an den Graben 14 angrenzt. Das dotierte Gebiet 15 ist n⁺- oder p⁺-dotiert und weist eine Dotierstoffkonzentration von zum Beispiel 1 x 10²⁰ cm⁻³ auf.

Es wird ganzflächig jeweils mit konformer Kantenbedeckung eine erste germaniumhaltige Schicht 16, eine Schicht aus dotiertem Silizium 17 und eine zweite germaniumhaltige Schicht 18 abgeschieden. Die erste germaniumhaltige Schicht 16 wird in einer Schichtdicke von zum Beispiel 25 nm abgeschieden. Die Schicht aus dotiertem Silizium 17 wird in einer Schichtdicke von 25 nm und mit einer Dotierstoffkonzentration von zum Beispiel 5 x 10²⁰ cm⁻³ abgeschieden. Sie weist denselben Leitfähigkeitstyp wie das dotierte Gebiet 15 auf. Die zweite germaniumhaltige Schicht 18 wird in einer Schichtdicke von zum Beispiel 25 nm abgeschieden. Der Schichtaufbau bestehend aus der ersten germaniumhaltigen Schicht 16, der Schicht aus dotiertem Silizium 17 sowie der zweiten germaniumhaltigen Schicht 18 wird durch CVD-Abscheidung in ein und demselben Reaktor unter Verwendung von Silan, Disilan und German als Prozeßgase gebildet. Bei der Abscheidung der Schicht aus dotiertem Silizium 17 wird zur insitu dotierten Abscheidung ein Dotiergas, zum Beispiel Phosphin oder Diboran zugegeben und der Germanfluß auf Null reduziert.

Durch anisotropes Rückätzen, zum Beispiel mit Cl₂/O₂ werden anschließend zur Hauptfläche 11 parallele Teile des Schichtaufbaus 16, 17, 18 entfernt. Dabei wird die Oberfläche der Grabenmaske 13 freigelegt. Am Boden des Grabens 14 wird die Oberfläche des dotierten Gebietes 15 freigelegt. Bei der anisotropen Ätzung verbleiben, ähnlich wie bei einer Spacerätzung, entlang den zur Hauptfläche 11 senkrechten Flanken des Grabens 14 angeordnete Teile der germaniumhaltigen Schichten 16, 18 und der Schicht aus dotiertem Silizium 17 (siehe Figur 2). Im oberen Bereich des Grabens 14 ist jeweils eine Oberfläche der germaniumhaltigen Schichten 16, 18 und der Schicht aus dotiertem Silizium 17 freigelegt. Die Ätzung erfolgt selbstjustiert, das heißt ohne Maske.

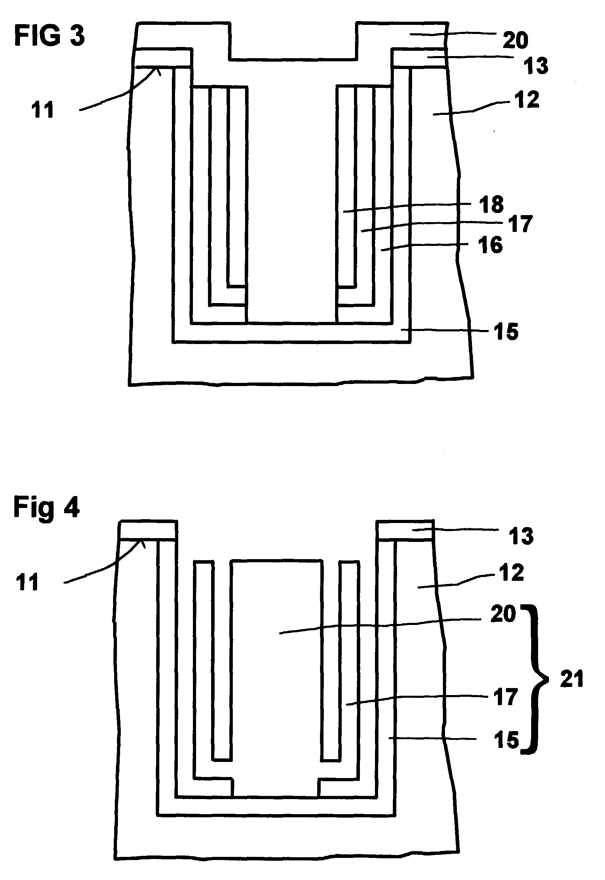

Es wird eine dotierte Polysiliziumschicht 20 mit im wesentlichen konformer Kantenbedeckung abgeschieden. Die dotierte Polysiliziumschicht 20 weist denselben Leitfähigkeitstyp wie die Schicht aus dotiertem Silizium 17 und eine Dotierstoffkonzentration von zum Beispiel 5 x 10²⁰ cm⁻³ auf. Mit der dotierten Polysiliziumschicht 20 wird der innere Grabenbereich vollständig aufgefüllt. Die dotierte Polysiliziumschicht 20 wird in einer Dicke von zum Beispiel 50 nm abgeschieden (siehe Figur 3).

Durch Rückätzen der dotierten Polysiliziumschicht 20 zum Beispiel mit Cl₂/O₂ werden auf der Grabenmaske 13 angeordnete Teile der dotierten Polysiliziumschicht 20 entfernt. Das Rückätzen wird solange fortgesetzt, bis im oberen Bereich des Grabens 14 die Oberfläche der germaniumhaltigen Schichten 16, 18 freigelegt ist. Durch eine zu dotiertem Polysilizium und Silizium selektive Ätzung werden anschließend die verbleibenden Teile der ersten germaniumhaltigen Schicht 16 und der zweiten germaniumhaltigen Schicht 18 entfernt. Die selektive Ätzung erfolgt zum Beispiel naßchemisch mit einer Ätzmischung, die HF, H₂O₂ und CH₃COOH enthält. Vorzugsweise liegt die Konzentration der Lösung in folgendem Bereich: 1 Teil HF, 200 Teile H₂O₂, 300 Teile CH₃COOH. Diese Ätzung weist in Bezug auf dotiertes Polysilizium eine Selektivität von 1:30 bis 1:1000 auf. In Bezug auf Siliziumoxid und Siliziumnitrid weist sie eine Selektivität von 1:30 bis 1:1000 auf.

Diese Ätzung erfolgt selektiv zur Grabenmaske 13. Bei dieser Ätzung werden weder die verbleibenden Teile der Schicht aus dotiertem Silizium 17 und der dotierten Polysiliziumschicht 20 noch die Oberfläche des dotierten Gebietes 15 angegriffen. Nach der Ätzung verbleibt im Graben 14 eine Elektrodenstruktur 21, die zusammengesetzt ist aus dem dotierten Gebiet 15, den verbleibenden Teilen der Schicht aus dotiertem Silizium 17 sowie der dotierten Polysiliziumschicht 20. Dabei bilden das dotierte Gebiet 15 sowie die verbliebenen Teile der Schicht aus dotiertem Silizium 17 zwei Lamellenelemente, die zwiebelförmig ineinander angeordnet sind. Die verbliebenen Teile der dotierten Polysiliziumschicht 20 bilden ein stabförmiges Stützelement, das innerhalb der Lamellenelemente angeordnet ist. Im Bereich des Grabenbodens sind die Lamellenelemente und das Stützelement durch den dort angeordneten Teil der dotierten Polysiliziumschicht 20 untereinander verbunden. Im Bereich der Grabenwände sind zwischen den verbliebenen Teilen der Schicht aus dotiertem Silizium 17, der dotierten Polysiliziumschicht 20 sowie dem dotierten Gebiet 15 durch das Herausätzen der germaniumhaltigen Schichten 16, 18 Abstände entstanden (siehe Figur 4). Die zylindrische Form der Schicht aus dotiertem Silizium 17 sorgt für eine ausreichende mechanische Stabilität der Elektrodenschichten, so daß ein Zusammenkleben benachbarter Schichten beim Trocknen nach dem Ätzen vermieden wird.

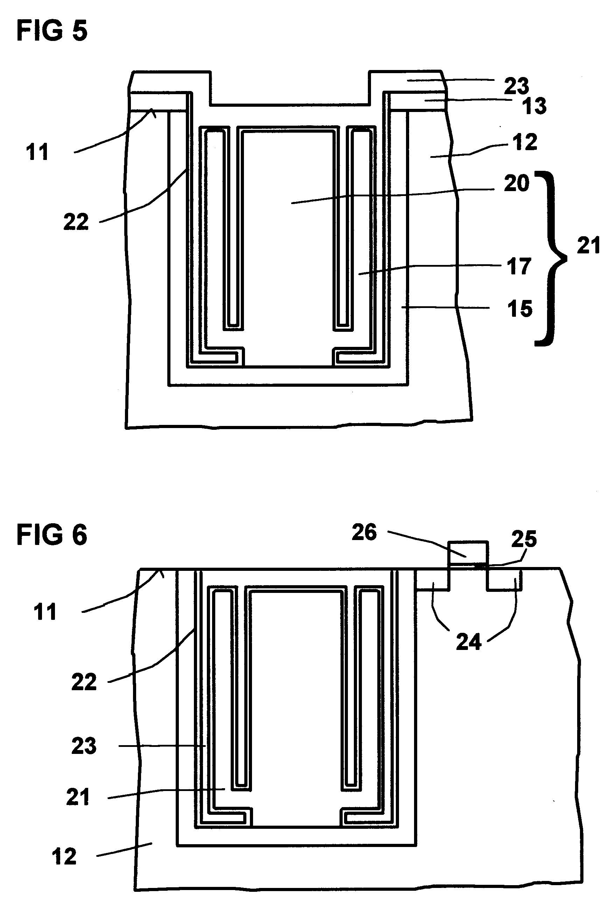

Die Oberfläche der Elektrodenstruktur 21 wird anschließend mit einem Speicherdielektrikum 22 versehen. Das Speicherdielektrikum 22 wird in einer Schichtdicke von zum Beispiel 7 nm erzeugt. Das Speicherdielektrikum 22 enthält SiO₂ und/oder Si₃N₄. Vorzugsweise wird das Speicherdielektrikum 22 als Mehrfachschicht mit einer ersten SiO₂-Schicht in einer Dicke von 1,5 nm, einer Si₃N₄-Schicht in einer Dicke von 5 nm und einer zweiten SiO₂-Schicht in einer Dicke von 1,5 nm gebildet. Zur Erzeugung einer Gegenelektrode 23 wird anschließend ganzflächig eine dotierte Polysiliziumschicht 23 abgeschieden, die eine im wesentlichen konforme Kantenbedeckung aufweist und die die Abstände zwischen dem dotierten Gebiet 15 und den verbliebenen Teilen der Schicht aus dotiertem Silizium 17 bzw. zwischen den Teilen der Schicht aus dotiertem Silizium 17 und der dotierten Polysiliziumschicht 20 auffüllt (siehe Figur 5). Der aus Elektrodenstruktur 21, Speicherdielektrikum 22 und Gegenelektrode 23 gebildete Speicherkondensator weist bei einer Grabentiefe von nur 2,5 µm und einem Grabendurchmesser von 0,2 µm eine Kapazität von größer als 25 fF auf.

In einer DRAM-Zellenanordnung sind pro Speicherzelle ein Speicherkondensator vorgesehen. Jede Speicherzelle umfaßt darüber hinaus einen Auswahltransistor mit Source/Drain-Gebieten 24, einem Gateoxid 25 und einer Gateelektrode 26, der zum Beispiel als planarer MOS-Transistor im Bereich der Hauptfläche 11 neben dem Speicherkondensator angeordnet ist (siehe Figur 6). Die Elektrodenstruktur 21, die den Speicherknoten des Speicherkondensators bildet, ist dabei mit einem der Source/Drain-Gebiete 24 verbunden. Das andere der Source/Drain-Gebiete 24 ist mit einer Bitleitung, die Gateelektrode 26 mit einer Wortleitung verbunden. Die Speicherzellen sind meist in Form von Zeilen und Spalten matrixartig angeordnet.

### Bezugszeichenliste

- 11: Hauptfläche
- 12: Halbleitersubstrat
- 13: Grabenmaske
- 14: Graben
- 15: dotiertes Gebiet
- 35: isolierende Spacer
- 16: erste germaniumhaltige Schicht
- 17: Schicht aus dotiertem Silizium
- 18: zweite germaniumhaltige Schicht
- 38: dotierte Polysiliziumschicht
- 39: dotiertes Gebiet
- 20: dotierte Polysiliziumschicht
- 21: Elektrodenstruktur
- 22: Kondensatordielektrikum
- 23: Gegenelektrode
- 24: Source/Drain-Gebiet
- 25: Gateoxid
- 26: Gateelektrode

## Patentansprüche

1. Verfahren zur Herstellung eines Kondensators für eine Halbleiteranordnung,
- bei dem in einer Hauptfläche (11) eines Halbleitersubstrates (12) ein Graben (14) geätzt wird,
- bei dem mindestens in dem Graben (14) eine Schichtenfolge abgeschieden wird, die jeweils alternierend eine Schicht aus dotiertem Silizium (17) und eine germaniumhaltige Schicht (16, 18) aufweist,
- bei dem die Schichten (16, 17, 18) der Schichtenfolge in demselben Reaktor abgeschieden werden,
- bei dem anschließend durch anisotropes Ätzen die Oberfläche des Halbleitersubstrats (12) im Bereich des Grabenbodens freigelegt wird,
- bei dem durch ganzflächige Abscheidung einer elektrisch leitfähigen Schicht (20), die den Graben auffüllt, und durch anisotropes Rückätzen der elektrisch leitfähigen Schicht (20) eine Stützstruktur (20) gebildet wird, die bis zum Grabenboden reicht,
- bei dem die germaniumhaltigen Schichten (16, 18) durch zu den Schichten aus dotiertem Silizium (17) und der Stützstruktur (20) selektives Ätzen entfernt werden,
- bei dem die freiliegende Oberfläche der Schichten aus dotiertem Silizium (17) und der Stützstruktur (20) mit einem Kondensatordielektrikum (22) versehen werden,
- bei dem an der Oberfläche des Kondensatordielektrikums (22) eine Gegenelektrode (23) gebildet wird.

2. Verfahren nach Anspruch 1,
- bei dem die Schichtenfolge in dem Graben (14) durch ganzflächiges Abscheiden der entsprechenden Schichten (16, 17, 18) erzeugt wird,
- bei dem anschließend durch anisotropes Ätzen zur Hauptfläche (11) parallele Teile der Schichten (16, 17, 18) entfernt werden, wobei die Oberfläche des Halbleitersubstrats (12) im Bereich des Grabenbodens freigelegt wird,
- bei dem durch ganzflächige Abscheidung einer elektrisch leitfähigen Schicht (20), die die Gräben jeweils auffüllt, und durch anisotropes Rückätzen der elektrisch leitfähigen Schicht (20) die Stützstruktur (20) gebildet wird.

3. Verfahren nach Anspruch 1 oder 2,
- bei dem die Schichten aus dotiertem Silizium (17) durch in situ dotierte Abscheidung von Polysilizium gebildet werden,
- bei dem die germaniumhaltigen Schichten (16, 18) durch Abscheidung von Germanium gebildet werden.

4. Verfahren nach einem der Ansprüche 1 bis 3,
bei dem die germaniumhaltigen Schichten (16, 18) einen Germaniumanteil zwischen 10 und 100 Mol% und einen Siliziumanteil zwischen 90 und 0 Mol% aufweisen.

5. Verfahren nach einem der Ansprüche 1 bis 4,
bei dem vor dem Aufbringen der Schichtenfolge in der Oberflä-che des Grabens (14) ein dotiertes Gebiet (15) gebildet wird, das mit der Stützstruktur (20) elektrisch und mechanisch verbunden ist.
